Europäisches Patentamt

(19) European Patent Office

Office européen des brevets

(11) EP 0 704 800 A2

## (12) EUROPEAN PATENT APPLICATION

(43) Date of publication:
03.04.1996 Bulletin 1996/14

(51) Int. Cl.⁶: $G06F\ 11/20$

(21) Application number: 95115350.1

(22) Date of filing: 28.09.1995

(84) Designated Contracting States:
DE FR GB

(30) Priority: 28.09.1994 JP 232731/94

(71) Applicant: NEC CORPORATION
Tokyo (JP)

(72) Inventor: Koshikawa, Yasuji,
c/o NEC Corporation
Tokyo (JP)

(74) Representative: Glawe, Delfs, Moll & Partner
Patentanwälte
Postfach 26 01 62
D-80058 München (DE)

(54) **Semiconductor memory device including redundant bit line selection signal generating circuit**

(57) A semiconductor memory device is capable of resetting a redundant bit line selection signal at high speed when an address signal is changed from a selective condition of a redundant bit line into a non-selective condition thereof. A semiconductor device for detecting that an input address is an address to be converted into a redundant bit line to cause a redundant bit line selection signal to become an active level, is comprised of: a control signal generating circuit for generating a control signal whose level is changed from a first level to a second level in synchronism with the change of the input address, and whose level becomes the first level after a predetermined time has elapsed; a charge circuit for electrically connecting a first power source terminal with a node when the control signal is at the first level, and

for electrically connecting the node with a second power source terminal when the control signal is at the second level; selecting means for electrically connecting the node with the second power source terminal when the input address corresponds to any address other than the address to be converted into the redundant bit, and for prohibiting the electric connection made between the node and the second power source terminal when the input address corresponds to the address to be converted into the redundant bit; and storage means for storing therein data corresponding to the level of the node when the control signal is at the first level and for producing the redundant bit line selection signal in response to the data.

FIG.4

EP 0 704 800 A2

## Description

## BACKGROUND OF THE INVENTION

### 1. Field of the Invention

The present invention relates to a semiconductor memory including a redundant bit line, more specifically, to a redundant bit line selection signal generating circuit for selecting a redundant bit line.

### 2. Description of the Prior Art

Recently, semiconductor memories are highly integrated. Therefore, it is very difficult to manufacture semiconductor memory devices, all of which memory cells are operable under normal conditions. Thus, semiconductor memories contain redundant memory cells, and faulty memory cells founded by memory checks are replaced by these redundant memory cells so as to improve a yield. Normally, faulty memory cells are replaced by redundant memory cells in unit of row, or column as redundant structures.

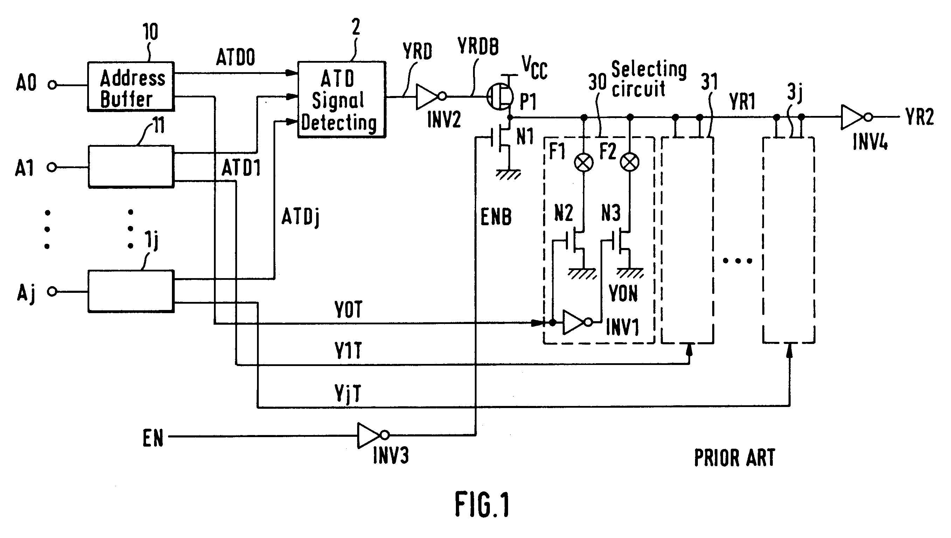

Referring to Fig. 1, a description will be made of such a conventional technique for substituting faulty cells by redundant memory cells in unit of column. In this figure, when a selection signal YR2 becomes an active level (namely, low level), a column decoder (not shown) selects a redundant bit line, and also prohibits an access to a bit line where a faulty memory cell is present.

External address signals A0 to Aj are supplied to address buffers 10 to 1j respectively every 1 bit. Each of address buffers produces column address signals Y0T to YjT corresponding to the 1-bit inputted address signals, respectively, and also produces address transition sensing signals ATD0 to ATDj when the inputted address signal is changed. As a consequence, when the external address signals A0 to Aj are changed, any one of the address transition sensing signals ATD0 to ATDj is produced.

An ATD signal detecting circuit 2 detects that any one of the address transition sensing signals ATD0 to ATDj is produced to thereby generate a sensing signal YRD having a predetermined pulse width. The sensing signal YRD is inverted by an inverter INV2, and the inverted sensing signal is supplied as a precharge signal YRDB to a gate of a P-channel transistor P1. The P-channel transistor P1 is provided between a power source terminal $V_{cc}$ and a node YR1. An N-channel transistor N1 is provided between the node YR1 and a ground source GND, and an enable signal EN is supplied via an inverter INV3 to a gate of this N-channel transistor N1.

Selecting circuits 30 to 3j are connected to the node YR1, to which corresponding column address signals Y0T to YjT are supplied. In each of the selecting circuits, an N-channel transistor N2 series-connected with a fuse F1, and another N-channel transistor N3 series-connected with another fuse N2 are provided between the node YR1 and the ground source GND, respectively. The column address signal (for example, Y0T) is supplied to a gate of the transistor N2, and this column address signal is inverted by the inverter INV1 into a signal Y0N which will then be supplied to a gate of the transistor N3.

When defect in the memory cell is found out by the memory check, an address of a faulty bit line is written into the selecting circuits 30 to 3j in order to replace the faulty bit line connected to this memory cell with a redundant bit line. Concretely speaking, any one of the fuses F1 and F2 provided in the selecting circuit is cut away by the laser trimming step in correspondence with the address of the faulty bit line. Such a fuse is cut away which is connected to the transistor that becomes conductive when the address of the faulty bit line is applied. As a result, when the address of the faulty bit line is applied, no current path is present between the node YR1 and the ground source, whereas when other addresses are applied, at least one current path is present.

A potential at the node YR1 is inverted by an inverter INV4, and then the inverted potential is outputted as a selection signal YR2.

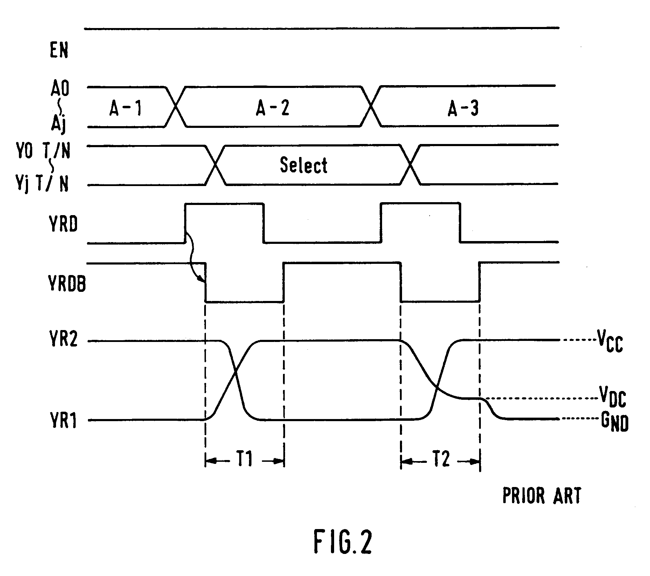

Referring now to a timing chart of Fig. 2, the conventional memory replacement shown in Fig. 1 will be described. Fig. 2 represents operation waveforms in the case that the address signals A0 to Aj are changed into A-1, A-2, A-3, and A-2 corresponds to an address of a faulty bit line.

Since the enable signal is at the high level during the read/write operations, the transistor N1 is under OFF state. When the address signal becomes A-1, at least one of these selection circuits 30 to 3j forms the current path between the ground source and the node YR1, so that the potential level at the node YR1 is equal to the ground potential, and the selection signal YR2 becomes the high level (i.e., inactive level).

Subsequently, when the address signal is changed into A-2, at least one of address transition sensing signals ATD0 to ATDj is produced, and the ATD signal detecting circuit 2 generates the sensing signal YRD having a predetermined pulse width. The sensing signal YRD is inverted by the inverter INV2 and the inverted sensing signal is supplied as the precharge signal YRDB to the gate of the P-channel transistor P1. As a result, the transistor P1 is brought into the ON state for a time period (T1) during which this precharge signal YRDB is at the low level. Since the address signal is "A-2" corresponding to the address of the faulty bit line, there is no current path between the ground source and the power source terminal $V_{cc}$ in the selection circuits 30 to 3j. Accordingly, the transistor P1 charges the node YR1 to $V_{cc}$ and causes the selection signal YR2 to become the low level (active level).

Next, when the address signal is changed into A-3, the precharge signal YRDB is supplied to the gate of the P-channel transistor P1, so that the P-channel transistor P1 is under ON state during a time period of T2. At this time, since the address signal A-3 is not the address of the faulty bit line, at least one of the selection circuits 30 to 3j forms the current path between the ground source and the node YR1. As a consequence, the level at the node YR1 is lowered from $V_{cc}$ to $V_{DC}$, so that the selection signal YR2 becomes the high level.

In the above-described operations, the DC level "$V_{DC}$" at the node YR1 while the precharge signal YRDB is at the low level and redundancy is unused may be determined based upon a conductive resistance value $R_P$ of the transistor P1, a conductive resistance value $R_N$ and a resistance value $R_F$ of the transistors N2, N3 under conducting state and the fuses F1, F2, and also the power supply voltage $V_{cc}$. Then, this DC level $V_{DC}$ is expressed by the following formula (1):

$$V_{DC} = (R_N + R_F) / (R_N + R_F + R_P) \times V_{cc} \quad (1).$$

The conductive resistance value $R_N$, and the resistance value $R_F$ are varied by the quantities of the N-channel type transistors under conducting state and of the fuses. These resistance values are decreased when the quantities of paired sets of the series-connected fuse F1/transistor N2 and fuse F2/transistor N3 are increased.

Accordingly, the condition under which the DC level $V_{DC}$ becomes the highest level when redundancy is unused corresponds to such a case that there is only one paired set of either the fuse F1/transistor N2 under conducting state or the fuse F2/transistor N3 under conducting state. The sizes of the transistors are so set as to achieve that a ratio of $R_P$ to $(R_F + R_N)$ may be defined by the following formula (2) in such a manner that the DC level $V_{DC}$ in this case is sufficiently lower than the threshold voltage of the inverter INV4 and the selection signal YR2 having the high level is outputted;

$$R_P : (R_F + R_N) = 2 : 1 \quad (2).$$

In this conventional semiconductor memory device, when the redundant bit line is changed from the selective condition into the non-selective condition (namely, changed from address signal A-2 to address signal A-3), the potential level at the node YR1 is varied from the power source level $V_{cc}$ to the DC level $V_{DC}$ corresponding to the intermediate potential. However, the time period during which this potential level at the node YR1 becomes lower than the threshold voltage of the inverter INV4 and the selection signal YR2 becomes the high level may greatly cause a problem in the DC level $V_{DC}$. In other words, the higher the DC level becomes, the lower the discharge capability with respect to the node YR1 becomes. That is, the smaller the total number of paired fuse F1/transistor N2 and fuse F2/transistor N3 under conductive states becomes, the lower the discharge capability becomes. As a result, the time period until the DC level $V_{DC}$ becomes lower than the threshold voltage of the inverter INV4 is prolonged. As a result, resetting of redundancy would be delayed.

Further, very currently, there is a trend that the stray capacitance of the node YR1 is increased since semiconductor memory devices are highly integrated and the quantity of selection circuits connected to this node YR1, namely a total number of fuses is increased. To precharge such a node having a large stray capacitance at high speed and to increase a selection speed of redundancy, the current capability of the precharging transistor P1 must be increased. In this case, the current capabilities of the transistors N2 and N3 employed in the selection circuit 3 should also be increased in view of the above-described equations (1) and (2). However, when the current capabilities of these transistors N2 and N3, namely the sizes of the transistors N2 and N3, are increased, the entire circuit area of semiconductor memory device should be increased.

BRIEF SUMMARY OF THE INVENTION

Therefore, an object of the present invention is to provide a semiconductor memory device capable of resetting a redundant bit line selection signal at high speed when an address signal is changed from a selective condition of a redundant bit line into a non-selective condition.

Summary of the Invention

A semiconductor device for detecting that an input address is an address to be converted into a redundant bit line to cause a redundant bit line selection signal to become an active level, is comprised of a control signal generating circuit for generating a control signal whose level is changed from a first level to a second level in synchronism with the change of the input address, and whose level becomes said first level after a predetermined time has elapsed, a charge circuit for electically connecting a first power source terminal with a node when control signal is at first level, and for electrically connecting the node with a second power source terminal when control signal is at second level, selecting means for electrically connecting the node with the second power source terminal when the input address corresponds to any address other than the address to be converted into said redundant bit, and for prohibiting the electric connection made between the node and the second power source terminal when input address corresponds to the address to be converted into said redundant bit, and storage means for storing therein data corresponding to the level of the node when control signal is at the first level and for producing the redundant bit fine selection signal in response to the data.

BRIEF DESCRIPTION OF THE DRAWINGS

The above-mentioned object and other objects, features and advantages of this invention will become more apparent by reference to the following detailed description of the invention taken in conjunction with the accompanying drawings, wherein:

Fig. 1 is a circuit diagram for showing the arrangement of the conventional redundant bit selecting circuit;

Fig. 2 shows the operational waveform chart for explaining the operation of the conventional redundant bit selecting circuit of Fig. 1;

Fig. 3 is a schematic block diagram of a semiconductor memory device for explaining an embodiment of the present invention;

Fig. 4 is a circuit diagram for indicating an concrete example of a redundant bit line selecting circuit represented in Fig. 3;

Fig. 5 indicates an operational diagram for explaining operations of the redundant bit line selecting circuit shown in Fig. 4;

Fig. 6 is a circuit diagram for representing another concrete example of the redundant bit line selecting circuit denoted in Fig. 3; and

Fig. 7 represents an operational waveform chart for explaining operations of the redundant bit line selecting circuit of Fig. 6.

## DETAILED DESCRIPTION OF THE INVENTION

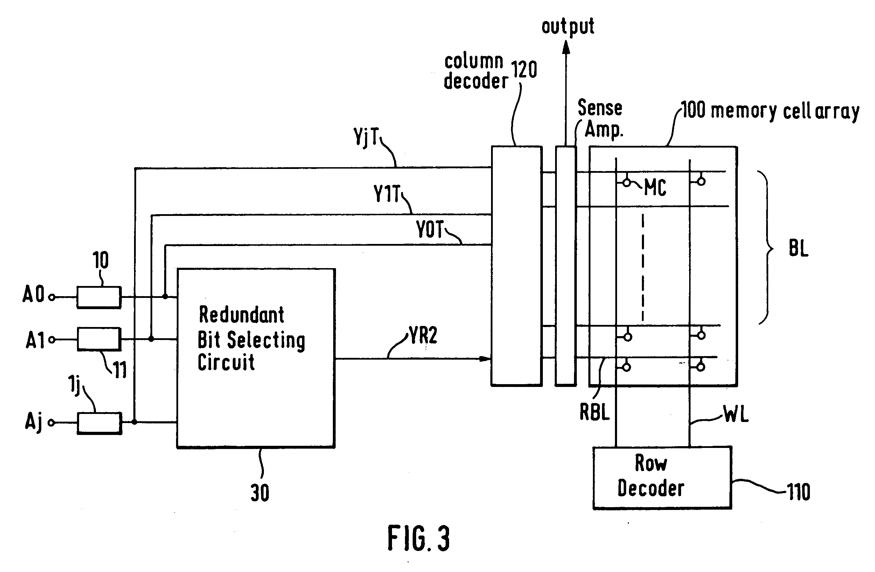

With reference to Figs. 3 to 5, a semiconductor memory device including a redundant bit line selecting circuit, according to an embodiment of the present invention, will now be described. As indicated in Fig. 3, external address signals A0 to Aj are supplied to address buffers 10 to 1j in unit of a single bit. The respective address buffers 10 to 1j generate column address signals Y0T to YjT corresponding to the inputted 1-bit address signal. In response to the column address signals Y0T to YjT, a column decoder 120 selects a predetermined bit line BL, so that both of a word line WL selected by a row decoder 110 and a memory cell MC located at a cross point of this bit line are selected. A redundant bit line RBL capable of substituting the bit line BL to which a faulty memory cell MC is connected is located within a memory cell array 100. When the selection signal YR2 becomes an active level, the column decoder 120 prohibits to select the bit line corresponding to the column address signal entered at this time, and also selects a redundant bit line RBL. When the address of the bit line BL to which the faulty memory cell MC is connected is applied, a redundant bit selecting circuit 30 causes the selection signal YR2 to become active.

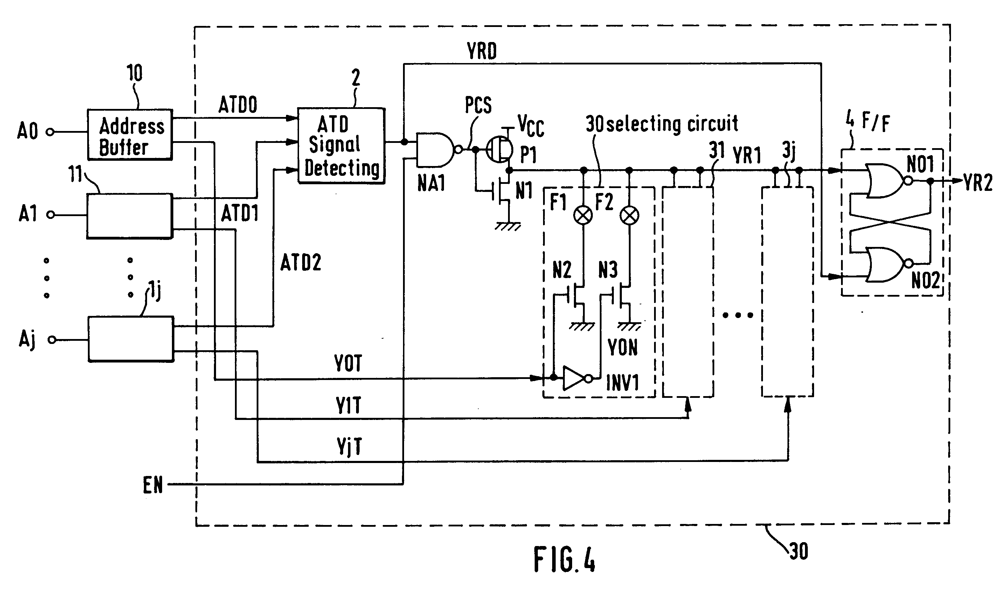

Referring now to Fig. 4, the redundant bit selecting circuit shown in Fig. 3 will be explained more in detail. It should be noted that the same reference numerals shown in the conventional information bit selecting circuit are employed as those for denoting the same or similar circuit elements of this redundant bit selecting circuit, and detailed descriptions thereof are omitted. Accordingly, this redundant bit selecting circuit represented in Fig. 3 owns the following different points. That is, a NAND gate NA1 is employed with having two inputs, namely the sensing signal YRD and the enable signal EN, generated from the ATD signal detecting circuit. Also, a precharge signal PCS corresponding to the output from the NAND gate NA1 is supplied to a gate of a P-channel transistor P1 and a gate of an N-channel transistor N1, which are series-connected between the power supply terminal $V_{cc}$ and the ground source GND. Furthermore, a flip-flop 4 is connected to a node YR1 and the sensing signal YRD is supplied to this flip-flop 4.

The flip-flop 4 is arranged by two sets of NOR gates N01 and N02, and an output of the NOR gate N01 is entered as a first input of the NOR gate N02, whereas an output of the NOR gate N02 is entered as a first input of the NOR gate N01. The node YR1 constitutes a second input of the NOR gate N01, and the sensing signal YRD constitutes a second input of the NOR gate N02. The flip-flop 4 functions as such a circuit that for a time period during which the sensing signal YRD is at the high level, an inverted potential level of the node YR1 is stored as a selection signal YR2, and the data stored for a time period during which the sensing signal YRD is at the high level is held even when the potential of the node YR1 is changed from the high level into the low level for a time period during which the sensing signal YRD is at the low level.

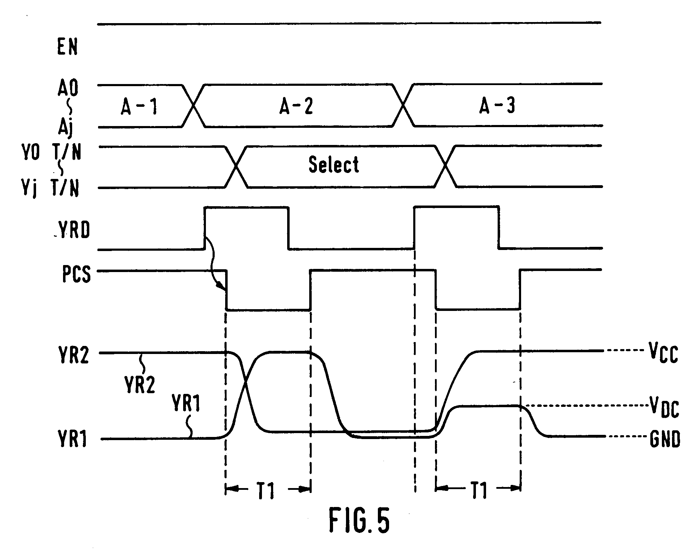

Operations of the redundant bit selecting circuit shown in Fig. 4 will now be explained with reference to Fig. 5. Fig. 5 indicates operational waveforms in such a case that the address signals A0 to Aj are changed into A-1, A-2, A-3, and A-2 corresponds to an address of a faulty bit line.

The enable signal is at a high level during read/write operations. Since the sensing signal YRD is at a low level just before the address signal is changed from A-1 to A-2, the precharge signal PCS is at a high level. Accordingly, the N-channel transistor N1 is brought into the ON state, so that the potential level at the node YR1 becomes the low level and the selection signal YR2 becomes the high level (namely, inactive level).

Subsequently, when the address signal is changed into A-2, the ATD signal detecting circuit 2 causes the low level of the sensing signal YRD to be changed into the high level for a preselected time period. As a consequence, the precharge signal PCS becomes the low level during the time period T1. In response to the level change of the precharge signal PCS into the low level, the P-channel transistor P1 is brought into the ON state, and the N-channel transistor N1 is brought into the OFF state, so that the charging operation to the node YR1 is carried out. At this time, since the address signal A-2 corresponds to the address of the faulty bit line, no current path is present in all of the selecting circuits 30 to 3j. As a result, the potential at the node YR1 is increased up to the power supply voltage $V_{cc}$. Since the sensing signal YRD is at the high level, the flip-flop 4 stores therein the data at the low level in response to $V_{cc}$ (high level) of the node YR1, and causes the selection signal YR2 to be brought into the low level (active level).

The precharge signal PCS becomes a high level after the time period T1 has elapsed. Accordingly, the P-channel transistor P1 is brought into the OFF state, and the N-channel transistor N1 is brought into the ON state, and also the potential at the node YR1 becomes the ground potential. At this time, since the sensing signal YRD is already at the low level, the flip-flop 4 maintains the low level (active level) of the selection signal YR2. It should be noted in this embodiment that the potential at the node YR1 is equal to the ground potential just before the address signal is changed from A-2 to A-3.

Next, when the address signal is changed into A-3, the precharge signal PCS becomes a low level during the time period of T1. At this time, the P-channel transistor P1 is brought into the ON state and the N-channel transistor N1 is brought into the OFF state. However, since the address signal A-3 is not equal to the address of the faulty bit line, at least one of the selecting circuits 30 to 3j forms a current path between the ground source and the node YR1. As a consequence, the level of the node YR1 is increased only up to $V_{DC}$ from the ground potential. Since the threshold voltage of the flip-flop 4 is set to be higher than the DC level $V_{DC}$, the selection signal YR2 becomes the high level (inactive level).

In the above-described embodiment, when the address signal is changed, the potential at the node YR1 is always equal to the ground potential. Consequently, in accordance with this embodiment, when the address signal is changed from the selective condition of the redundant bit line into the non-selective condition thereof, since no operation to discharge the node YR1 is carried out, the discharge capability of the selecting circuit gives no adverse influence to the time period during which the selection signal YR2 is varied. In other words, this embodiment owns such an effect that the redundant bit line selection signal can be reset at high speed. Moreover, even when the drive capability of the P-channel transistor P1 for charging the node YR1 is increased, since no adverse influence is given to the resetting time of the redundant bit line selection signal, there is an advantage that the precharge time can be shortened.

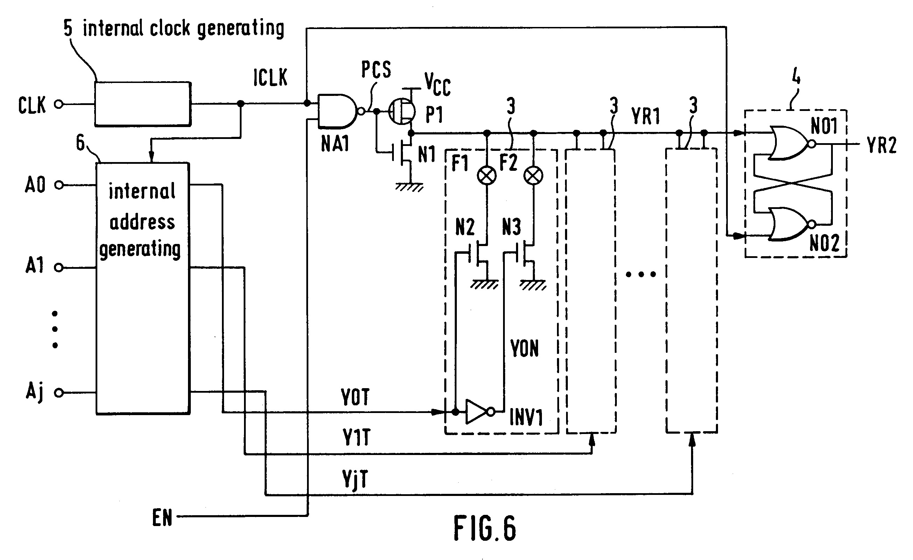

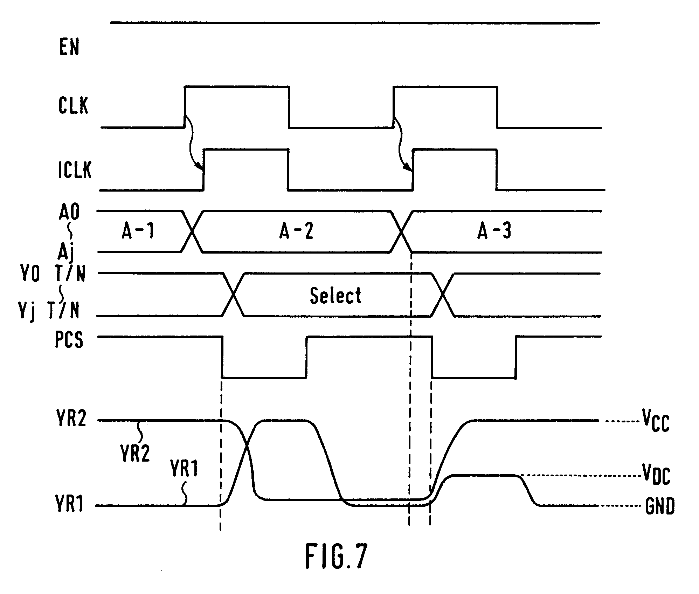

Referring to Fig. 6, a semiconductor memory device including a redundant bit line selecting signal generating circuit according to a second embodiment of the present invention will be described. A difference point of this second embodiment, as compared with the first embodiment shown in Fig. 4, is such that a clock signal ICLK derived from an internal clock generating circuit 5 is employed instead of the sensing signal YRD supplied to the NAND gate NA1 and the flip-flop 4. The internal clock generating circuit 5 is a circuit for generating a clock required to the internal operation in response to an external clock externally supplied. The internal clock signal ICLK corresponds to a control clock used to acquire an address, and is furnished to an internal address generating circuit 6. Accordingly, a column address is changed in response to the change in the clock ICLK. As shown in Fig. 7, the clock signal ICLK becomes a high level for a preselected time in synchronism with the change in the address signal. This waveform is identical to that of the sensing signal YRD represented in Fig. 5. Since operations of the second embodiment are the same as those of the first embodiment, no explanations thereof are omitted.

Although the invention has been described with reference to specific embodiments, this description is not meant to be construed in a limiting sense. Various modifications of the disclosed embodiments will become apparent to persons skilled in the art upon reference to the description of the invention. It is therefore contemplated that the appended claims will cover any modifications or embodiments as fall within the true scope of the invention.

## Claims

1. A semiconductor device for detecting that an input address is an address to be converted into a redundant bit line to cause a redundant bit line selection signal to become an active level, comprising:

   a control signal generating circuit for generating a control signal whose level is changed from a first level to a second level in response to the change of said input address, and whose level becomes said first level after a predetermined time has elapsed;

   a charge circuit for electrically connecting a first power source terminal with a node when said control signal is at said first level, and for electrically connecting said node with a second power source terminal when said control signal is at said second level;

   selecting means for electrically connecting said node with said second power source terminal when said input address corresponds to any address other than the address to be converted into said redundant bit, and for prohibiting the electric connection made between said node and said second power source terminal when said input address corresponds to the address to be converted into said redundant bit; and

   storage means for storing therein data corresponding to the level of said node when said control signal is at the first level and for producing said redundant bit line selection signal in response to said data.

2. A semiconductor device as claimed in claim 1, wherein said control signal generating circuit is an address change detecting circuit for detecting that said input address is changed to thereby generate said control signal.

3. A semiconductor device as claimed in claim 1, wherein said control signal generating circuit is an internal clock generating circuit for generating a control clock used to acquire said input address.

4. A semiconductor device as claimed in claim 1, wherein said storage means is arranged by including a first logic gate such that a potential at said node is used as a first input and an output thereof is used as said redundant bit line selection signal; and a second logic gate such that a first input is used as said control signal, a second input is used as an output of said first logic gate, and an output thereof is used as a second input of said first logic gate.

5. A semiconductor device as claimed in claim 4, wherein said first and second logic gates are a two-input NOR gate.

6. A semiconductor device as claimed in claim 1, wherein said charge circuit is a CMOS inverter circuit provided between said first power source terminal and said second power source terminal.

7. A semiconductor device comprising:

a pulse signal generating circuit for generating a pulse signal for a predetermined time in response to a change of an input address;

a first transistor provided between a first power source terminal and a node, and conducted when said pulse signal is generated;

a second transistor provided between a second power source terminal and said node, and conducted when said pulse signal is not generated;

a selecting circuit for forming a current pulse between said node and said second power source terminal, and for prohibiting the formation of said current pulse when said input address is a predetermined address; and

storage means for storing therein data corresponding to a level of said node within a time period during which said pulse signal is generated.

8. A semiconductor device as claimed in claim 7, wherein said storage means is arranged by including a first logic gate such that a potential at said node is used as a first input and an output thereof is used as said redundant bit line selection signal; and a second logic gate such that a first input is used as said control signal, a second input is used as an output of said first logic gate, and an output thereof is used as a second input of said first logic gate.

9. A semiconductor device as claimed in claim 8, wherein said first and second logic gates are a two-input NOR gate.

10. A semiconductor device for selecting a redundant bit line when an input address is a predetermined address and prohibiting an access to a bit line corresponding to said predetermined address, comprising:

precharge means for connecting a node with a first power source terminal during a preselected time in response to a change of an input address and thereafter for connecting said node with a second power supply terminal;

switch means provided between said node and said second power supply terminal, said switch means being brought into a non-conductive state when said input address corresponds to said predetermined address;

storage means for storing therein a level of said node during said predetermined time and for producing a redundant bit line selection signal in response to the stored level; and

control means for selecting said redundant bit line in response to the generation of said redundant bit line selection signal, and for prohibiting an access to a bit line corresponding to said predetermined address.

FIG.1

PRIOR ART

7

PRIOR ART

FIG.2

FIG. 3

EP 0 704 800 A2

FIG.4

EP 0 704 800 A2

FIG.5

FIG.6

EN

CLK

ICLK

A0 ~ Aj

V0 T/N

Yj T/N

PCS

YR2

YR1

A-1   A-2   A-3

Select

YR2   YR1

VCC

VDC

GND

# FIG.7